# EUROPEAN PATENT APPLICATION

(11) **EP 2 866 055 A1**
(43) Date of publication of application: **29.04.2015**
(21) Application number: 14181009.3
(22) Date of filing: 14.08.2014
(51) Int. Cl.: G01T 1/20

(54) **Photodetector**

(30) Priority: 23.10.2013 JP 2013220533
(71) Applicant: Kabushiki Kaisha Toshiba, Tokyo 105-8001 (JP)
(72) Inventor: Sasaki, Keita, Tokyo, 105-8001 (JP); Hasegawa, Rei, Tokyo, 105-8001 (JP)
(74) Representative: Hoffmann Eitle

(57) **Abstract**

According to an embodiment, a photodetector includes a scintillator layer (18), a photodetection layer (12), an antireflective member (20), and an intermediate layer (25). The scintillator layer (18) is configured to convert radiation into light. The photodetection layer has a first surface facing the scintillator layer. The photodetection layer includes a pixel region (16) including multiple photodetection devices (14) configured to detect light, and a peripheral region (17) that surrounds the pixel region. The pixel and peripheral regions are provided on the first surface. The antireflective member is provided between the scintillator layer and the photodetection layer and opposed to at least part of the peripheral region. The antireflective member is configured to prevent reflection of at least part of light in a sensitive wavelength range of the photodetection devices. The intermediate layer is provided in a region other than the antireflective member between the scintillator and photodetection layers.

## Description

### FIELD

Embodiments described herein relate generally to a photodetector.

### BACKGROUND

Photodetection devices such as a silicon photo-multiplier (SiPM) having multiple avalanche photodiodes (APDs) arranged therein are known. A SiPM is driven in a range called Geiger mode by operating APDs under a high reverse bias voltage condition higher than the breakdown voltage of the APDs. The gain of the APDs during operation in the Geiger mode is in a range of 10⁵ to 10⁶, which is very high, and even weak light of one photon can be measured.

Furthermore, a device combining a photodetection device using multiple pixels each including multiple APDs and a scintillator that converts X-rays into light is disclosed. Combination of a photodetection device and a scintillator allows a photon counting image having a spatial resolution depending on the size of the scintillator to be obtained. For example, a technology for obtaining a computed tomography (CT) image by detecting X-rays by using combination of a photodetection device and a scintillator is also known.

In the related art, however, optical crosstalk between pixels may be caused by multiple reflection of photons in a layer between a scintillator and a photodetection device.

### BRIEF DESCRIPTION OF THE DRAWINGS

FIG. 1 is a diagram illustrating a photodetector;
FIG. 2 is a sectional view taken along A-A' in FIG. 1;
FIG. 3 is a diagram for explaining motion of photons in a photodetector of the related art;
FIG. 4 is a diagram for explaining motion of photons in a photodetector;
FIG. 5 is a diagram for explaining a method for manufacturing a photodetector;
FIG. 6 is a diagram for explaining the method for manufacturing a photodetector;
FIG. 7 is a diagram for explaining the method for manufacturing a photodetector;
FIG. 8 is a diagram for explaining the method for manufacturing a photodetector;
FIG. 9 is a diagram for explaining the method for manufacturing a photodetector;
FIG. 10 is a diagram for explaining the method for manufacturing a photodetector;
FIG. 11 is a diagram for explaining the method for manufacturing a photodetector;
FIG. 12 is a diagram for explaining the method for manufacturing a photodetector;
FIG. 13 is a diagram illustrating another photodetector;
FIG. 14 is a diagram illustrating still another photodetector;
FIG. 15 is a diagram illustrating still another photodetector; and
FIG. 16 is a diagram illustrating still another photodetector.

### DETAILED DESCRIPTION

According to an embodiment, a photodetector includes a scintillator layer, a photodetection layer, an antireflective member, and an intermediate layer. The scintillator layer is configured to convert radiation into light. The photodetection layer has a first surface facing the scintillator layer. The photodetection layer includes a pixel region that includes multiple photodetection devices configured to detect light, and a peripheral region that surrounds the pixel region. The pixel region and the peripheral region are provided on the first surface. The antireflective member is provided between the scintillator layer and the photodetection layer and opposed to at least part of the peripheral region. The antireflective member is configured to prevent reflection of at least part of light in a sensitive wavelength range of the photodetection devices. The intermediate layer is provided in a region other than the antireflective member between the scintillator layer and the photodetection layer.

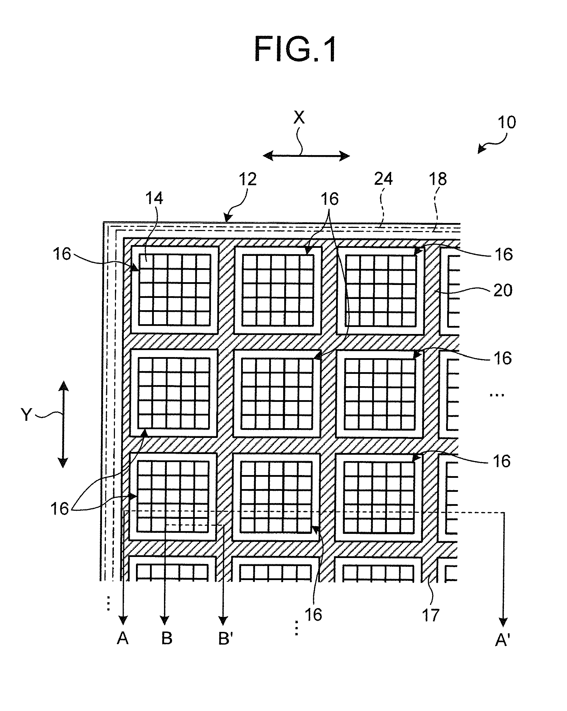

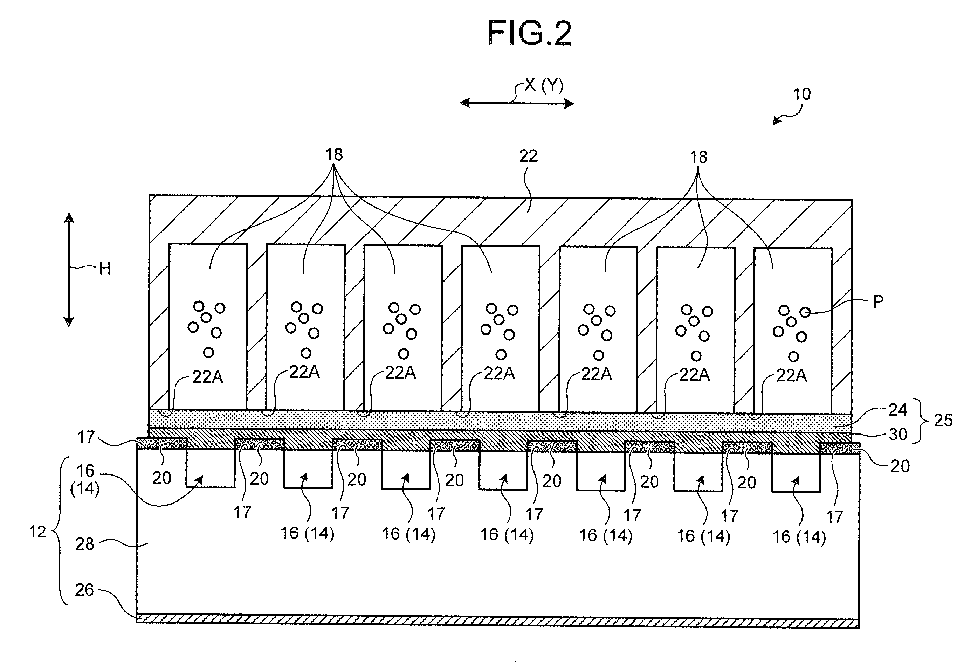

Details of an embodiment will be described below with reference to the accompanying drawings. FIG. 1 is a diagram illustrating an example of a photodetector 10. FIG. 2 is a sectional view taken along A-A' in FIG. 1.

A photodetector 10 includes a photodetection layer 12, a scintillator layer 18, an intermediate layer 25, a reflective member 22, and an antireflective member 20.

The scintillator layer 18 converts radiation into light (photons P). The scintillator layer 18 is made of a scintillator material. When radiation such as X-rays enters the scintillator material, the scintillator material produces fluorescence (scintillation light). In the description of the present embodiment, fluorescence (scintillation light) produced by the scintillator layer 18 will be referred to as light or photons P. The scintillator material is selected as appropriate depending on the application of the photodetector 10. Examples of the scintillator material include Lu₂SiO₅:(Ce), LaBr₃:(Ce), YAP (yttrium aluminum perovskite) :Ce, and Lu(Y)AP:Ce, but the scintillator material is not limited thereto.

The photodetection layer 12 detects light resulting from the conversion by the scintillator layer 18. The photodetection layer 12 is a silicon photo-multiplier (SiPM) having multiple avalanche photodiodes (APDs) 14 that are photodetection devices arranged therein.

As illustrated in FIG. 1, the APDs 14 are arranged in a matrix (refer to the direction of an arrow X and the direction of an arrow Y in FIG. 1). The photodetection layer 12 has a structure in which multiple pixel regions 16 each being one pixel (pixel region 16) including multiple APDs 14 are arranged in a matrix. Specifically, the photodetection layer 12 includes the pixel regions 16 each including multiple APDs 14 that detect light and a peripheral region 17 surrounding the pixel regions 16 on a first surface facing the scintillator layer 18.

FIG. 1 illustrates a structure in which each pixel region 16 includes 25 (5 x 5) APDs 14 arranged therein. The number of APDs 14 included in each pixel region 16, however, is only an example and not limited to 25.

The APDs 14 are known avalanche photodiodes. In the present embodiment, the APDs 14 are driven in the Geiger mode.

As illustrated in FIG. 2, the photodetection layer 12 is a laminate of an electrode layer 26, a semiconductor substrate 28, and the pixel regions 16 laminated in this order.

The intermediate layer 25 is provided in an area excluding the antireflective member 20 (details of which will be described later) between the scintillator layer 18 and the photodetection layer 12. In the present embodiment, the intermediate layer 25 is a laminate of an insulating layer 30 and an adhesive layer 24. As described above, the intermediate layer 25 is provided in an area excluding the antireflective member 20 (details of which will be described later) between the scintillator layer 18 and the photodetection layer 12. Specifically, the intermediate layer 25 may be any layer satisfying this condition, and may include only the adhesive layer 24 or may be a laminate further including another layer. If the insulating layer 30 is used as one of the layers constituting the photodetection layer 12, for example, the insulating layer 30 does not correspond to a layer included in the intermediate layer 25 in the present embodiment.

The adhesive layer 24 is a layer for bonding the scintillator layer 18 and the insulating layer 30. The adhesive layer 24 may be any layer having functions of transmitting light emitted from the scintillator layer 18 to the photodetection layer 12 and bonding the scintillator layer 18 and the photodetection layer 12.

The insulating layer 30 is provided between the photodetection layer 12 and the adhesive layer 24. More specifically, the insulating layer 30 is positioned in contact with surfaces of the photodetection layer 12 and the antireflective member 20, which will be described layer, facing the scintillator layer 18. The insulating layer 30 is made of an insulating material. The insulating layer 30 is made of an insulating material that transmits light emitted from the scintillator layer 18 to the photodetection layer 12.

The reflective member 22 is a member that reflects photons P resulting from the conversion by the scintillator layer 18. The reflective member 22 may be any member made of a material having a function of reflecting photons P.

The reflective member 22 is positioned in a manner that the scintillator layer 18 is divided into regions associated with the pixel regions 16. The scintillator layer 18 is thus divided into regions associated with the pixel regions 16 by the reflective member 22. Although an embodiment in which the photodetector 10 includes the reflective member 22 is described in the present embodiment, the photodetector 10 may have a structure not including the reflective member 22.

The photodetector 10 in the present embodiment includes the antireflective member 20. The antireflective member 20 is provided between pixel regions 16 (hereinafter may also be referred to as between pixels) on the surface of the photodetection layer 12 facing the scintillator layer 18.

The antireflective member 20 is provided between the scintillator layer 18 and the photodetection layer 12, and is opposed to at least part of the peripheral region 17. The antireflective member 20 is provided between the pixel regions 16 on the surface facing the scintillator layer 18, and is opposed to at least part of the peripheral region 17. The antireflective member 20 prevents reflection of at least part of light in a sensitive wavelength range of the photodetection devices.

A first surface of the photodetection layer 12 is a flat surface containing light receiving surfaces of the pixel regions 16 and parallel to the X direction and the Y direction. In the present embodiment, the first surface of the photodetection layer 12 is in contact with or across the antireflective member 20.

In the example illustrated in FIG. 1, the antireflective member 20 is continuous and surrounds the pixel regions 16 on the surface of the photodetection layer 12 facing the scintillator layer 18. Furthermore, in the example illustrated in FIGS. 1 and 2, the antireflective member 20 has a width equal to the distance between pixels.

As illustrated in FIG. 2, the antireflective member 20 is preferably provided in a region opposed to the reflective member 22 on the surface of the photodetection layer 12 facing the scintillator layer 18. More specifically, a surface 22A of the reflective member 22 in contact with the adhesive layer 24 and opposed to the photodetection layer 12 and the antireflective member 20 are opposed to each other.

In the example illustrated in FIG. 2, the antireflective member 20 is in contact with the first surface of the photodetection layer 12 and has a rectangular shape protruding from the first surface toward the scintillator layer 18. Specifically, the first surface of the photodetection layer 12 is in contact with the antireflective member 20 and covered by the intermediate layer 25. Note that the cross-sectional shape of the antireflective member 20 in parallel to the first surface is not limited to a rectangle.

The antireflective member 20 prevents reflection of at least part of light in a sensitive wavelength range of the APDs 14 included in the pixel regions 16. The antireflective member 20 is made of SiN, for example. The antireflective member 20 has the following structure to exhibit the function of reflecting light in the sensitive wavelength range of the APDs 14.

For example, the materials of the antireflective member 20 and the insulating layer 30 are adjusted so that the refractive index of the antireflective member 20 and that of a layer (the insulating layer 30 in FIG. 2) provided in contact with the antireflective member 20 on the side of the scintillator layer 18 are different from each other, for example. As a result of adjusting the materials so that the refractive index of the antireflective member 20 and that of the insulating layer 30 are different from each other, reflection of photons P propagating from the scintillator layer 18 through the adhesive layer 24 and the insulating layer 30 and reaching the antireflective member 20 can be prevented. Such an antireflective member 20 can be obtained by appropriately selecting the materials depending on the sensitive wavelength range of the APDs 14 and the refractive index of the insulating layer 30.

Preferably, the antireflective member 20 has a refractive index higher than that of the insulating layer 30. More preferably, the antireflective member 20 has a refractive index higher than that of the layer (the insulating layer 30) in contact with the antireflective member 20 on the side of the scintillator layer and lower than that of the layer in contact with the other side of the antireflective member 20.

As a result of adjusting the refractive indices of the antireflective member 20, the insulating layer 30, and the respective regions of the photodetection layer 12 in contact with the antireflective member 20 to satisfy the relations described above, reflection of photons P reaching the antireflective member 20 can be effectively prevented. The antireflective member 20 having a refractive index higher than that of the insulating layer 30 and lower than that of the photodetection layer 12 can be obtained by appropriately selecting the materials depending on the sensitive wavelength range of the APDs 14 and the materials of the insulating layer 30 and the photodetection layer 12.

Alternatively, a member for canceling and interfering with incident light may be used as the antireflective member 20. In this case, the thickness (the length in the direction of an arrow H in FIG. 2) of the antireflective member 20 and the materials of the antireflective member 20 may be adjusted so as to cancel and interfere with the incident light.

Specifically, the thickness and the materials of the antireflective member 20 may be adjusted to have an optical distance that is 1/4 of the wavelength of light incident on the antireflective member 20.

For example, the antireflective member 20 is made of a laminate of a SiN layer on a SiO layer or of a SiN layer. The thickness of the SiN layer may then be adjusted so that light incident on the antireflective member 20 is cancelled and interfered with. Specifically, when the wavelength of light incident on the antireflective member 20 from the scintillator layer 18 is 400 nm, the thickness of the antireflective member 20 is adjusted to 50 nm and the material therefor is a SiN layer having a refractive index of 2.0 so that the optical distance will be 100 nm.

Alternatively, a diffraction grating or a liquid crystal that cancels and interferes with light incident on the antireflective member 20 may be used as the antireflective member 20.

Alternatively, the antireflective member 20 may be made of a member that absorbs at least light in the sensitive wavelength range of the APDs 14. In this case, the antireflective member 20 may have a pigment or a dye that absorbs light in the sensitive wavelength range dispersed in the layer, for example. A black pigment or a black dye, for example, is used as the pigment or dye. Preferably, the surface of the pigment is covered with an insulating material.

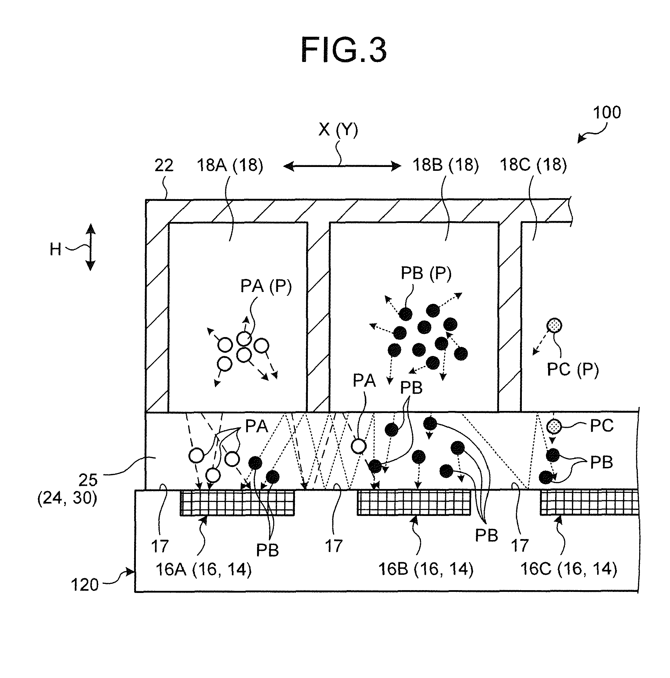

With a photodetector of the related art that does not include the antireflective member 20, optical crosstalk between pixels may be caused owing to multiple reflection of photons P in the intermediate layer 25 between the scintillator layer 18 and the photodetection layer 12. FIG. 3 is a diagram for explaining motion of photons P in a photodetector 100 of the related art.

In the photodetector 100 of the related art, the scintillator layer 18 is provided on a photodetection layer 120 having multiple APDs 14 arranged in each pixel region 16 with the intermediate layer 25 such as the adhesive layer 24 therebetween. The scintillator layer 18 is divided into regions associated with the pixel regions 16 by the reflective member 22. In the photodetector 100 of the related art, however, the antireflective member 20 (see FIGS. 1 and 2) according to the present embodiment is not provided.

In the example illustrated in FIG. 3, scintillator layers 18A to 18C obtained by the division by the reflective member 22 are provided in association with the pixel regions 16A to 16C of the photodetection layer 120.

The scintillator layer 18 converts radiation incident thereon into light (photons P). In the example illustrated in FIG. 3, the scintillator layer 18A associated with the pixel region 16A converts radiation incident thereon into photons PA. The scintillator layer 18B associated with the pixel region 16B converts radiation incident thereon into photons PB. The scintillator layer 18C associated with the pixel region 16C converts radiation incident thereon into photons PC.

The pixel regions 16A to 16B will be collectively referred to as the pixel regions 16 in the description. The photons PA to PC will be collectively referred to as the photons P in the description. Furthermore, the scintillator layers 18A to 18C will be collectively referred to as the scintillator layer 18 in the description.

When photons P (photons PA to PC) caused by the scintillator layer 18 (scintillator layers 18A to 18C) associated with the pixel regions 16 (pixel regions 16A to 16C) enter the associated pixel regions 16 (pixel regions 16A to 16C), the photodetection layer 120 can accurately count the number of photons in each of the pixel regions 16.

Photons P emitted from the scintillator layer 18 may, however, propagate through the intermediate layer 25 in the direction in which the pixel regions 16 are arranged and reach another pixel region 16. More specifically, as illustrated in FIG. 3, the photons PB resulting from the conversion by the scintillator layer 18B may be subject to multiple reflection in the intermediate layer 25 and propagate to a pixel region 16 other than the associated pixel region 16B (the adjacent pixel region 16A or 16C, for example). In other words, optical crosstalk is caused in the related art.

The description refers back to FIG. 2, in which the photodetector 10 of the present embodiment includes the antireflective member 20 between pixels on the surface of the photodetection layer 12 facing the scintillator layer 18. As a result of including the antireflective member 20, optical crosstalk between pixels can be reduced.

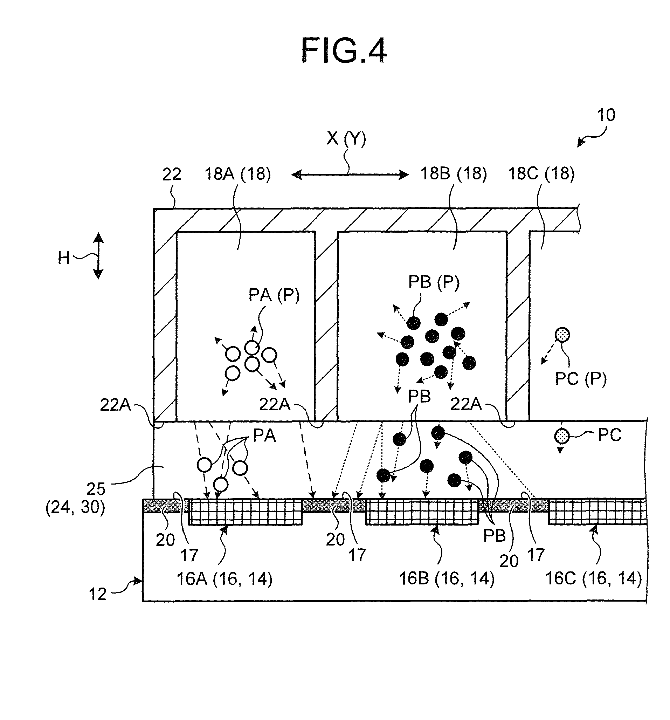

FIG. 4 is a diagram for explaining motion of photons P in the photodetector 10 of the present embodiment.

The scintillator layer 18 converts radiation incident thereon into light (photons P). In the example illustrated in FIG. 4, the scintillator layer 18A associated with the pixel region 16A converts radiation incident thereon into photons PA similarly to FIG. 3. The scintillator layer 18B associated with the pixel region 16B converts radiation incident thereon into photons PB. The scintillator layer 18C associated with the pixel region 16C converts radiation incident thereon into photons PC.

Even if the photons P (photons PA to PC) resulting from the conversion by the scintillator layers 18A to 18C propagate through the intermediate layer 25, reflection thereof is prevented by the antireflective member 20 provided between the pixels. More specifically, as illustrated in FIG. 4, even if the photons PB generated by the scintillator layer 18B propagate through the intermediate layer 25 in the direction in which the pixel regions 16 are arranged, reflection thereof is prevented at the point when the photon PB reach the antireflective member 20 provided between the pixels. Thus, photons P are not detected in the pixel regions 16 around the associated pixel region 16, and optical crosstalk is prevented.

As described above, the photodetector 10 in the present embodiment includes the antireflective member 20. As a result, photons P resulting from the conversion by the scintillator layers 18A to 18C are prevented from propagating through the intermediate layer 25 to pixel regions 16 other than the associated pixel regions 16.

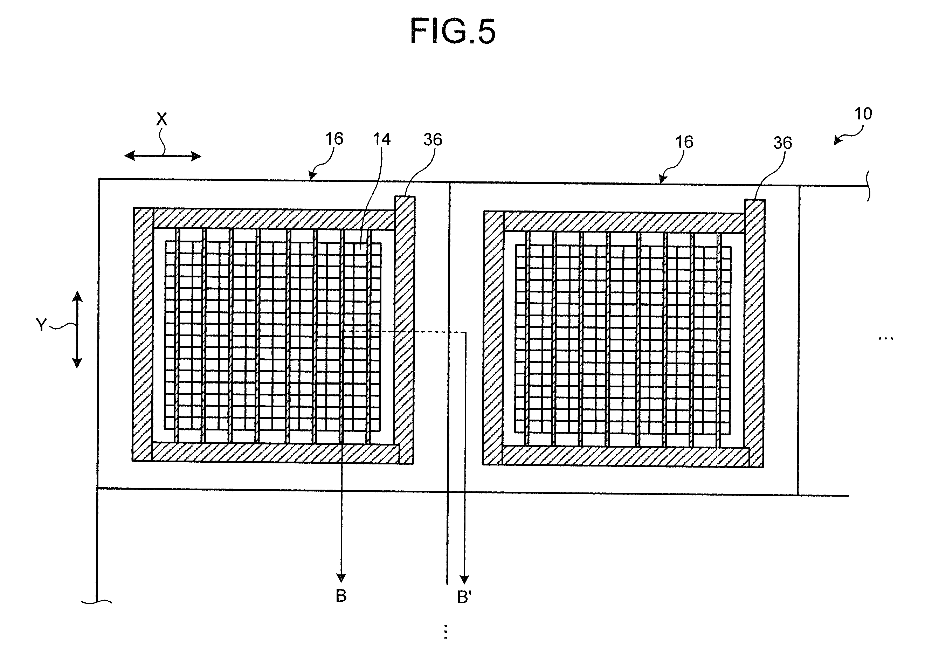

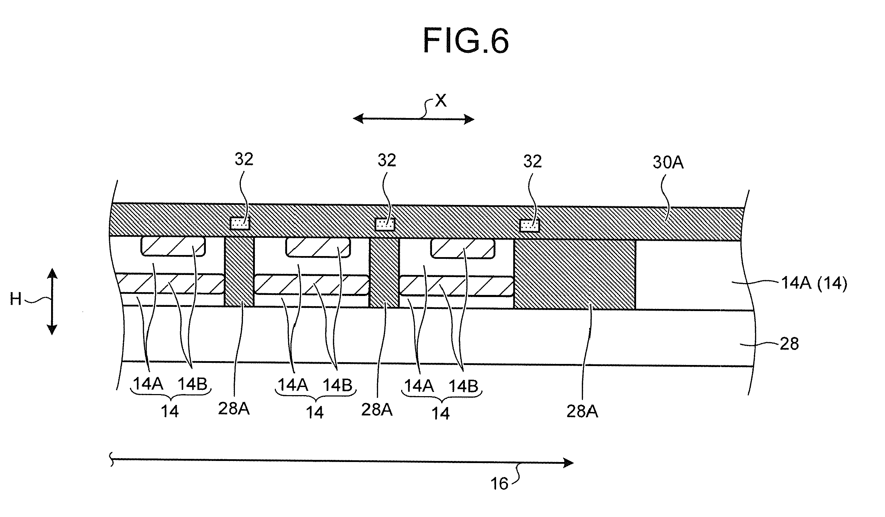

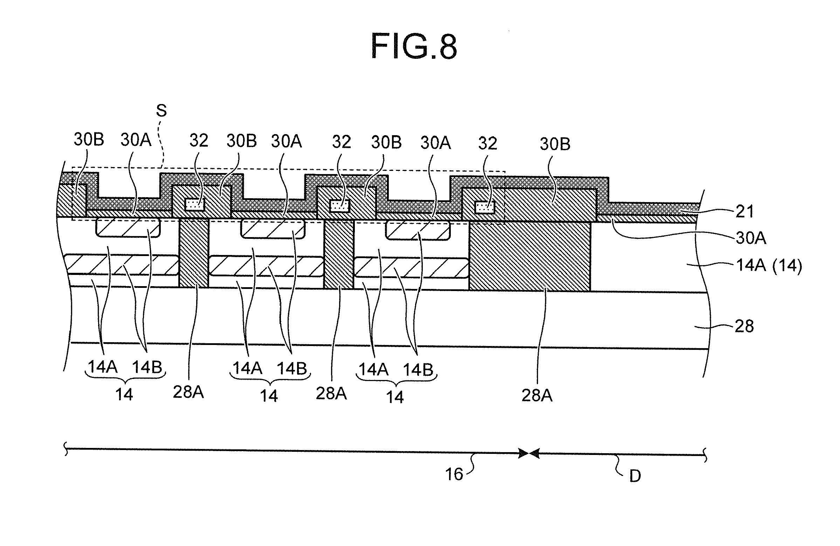

Next, a method for manufacturing the photodetector 10 of the present embodiment will be described. FIGS. 5 to 12 are explanatory diagrams illustrating an example of the method for manufacturing the photodetector 10. FIGS. 6 to 12 are sectional view taken along B-B' in FIGS. 1 and 5. In FIGS. 8 to 12, a region indicated by an arrow D corresponds to a region between pixel regions 16.

FIG. 5 is a plan view of the photodetector 10. The APDs 14 provided in the respective pixel regions 16 are connected to an output pad (not illustrated) via a wiring layer 36. In FIG. 5, components other than the pixel regions 16, the APDs 14, and the wiring layer 36 are not illustrated.

The APDs 14 are formed together by applying a semiconductor manufacture process to a semiconductor substrate. Specifically, as illustrated in FIG. 6, an N-type semiconductor substrate 28 is first provided. Subsequently, a p- semiconductor layer 14A is formed in the N-type semiconductor substrate 28 through epitaxial growth. An impurity (boron, for example) is implanted so that part of the p- semiconductor layer becomes a p+ semiconductor layer 14B. As a result, multiple APDs 14 are formed on the n-type semiconductor substrate 28. The length of each APD 14 in the direction in which the APDs 14 are arranged (the direction of an arrow X or the direction of an arrow Y) is 800 µm, for example.

Subsequently, device isolation of the APDs 14 is performed so that the APDs 14 will not electrically interfere with one another. The device isolation is achieved by making the region between the APDs 14 have a deep trench isolation structure, or a channel stopper structure through implantation of impurity (phosphorus, for example). As a result of the device isolation, a channel stopper region 28A is formed between the APDs 14.

For the device isolation, the region between the pixel regions 16 each including multiple APDs 14 on the surface of the p- semiconductor layer 14A on which the scintillator layer 18 is to be provided is adjusted to be made of Si. Specifically, the surface of the channel stopper region 28A on which the scintillator layer 18 is to be made is adjusted to be made of Si.

Subsequently, an insulating layer 30A is formed on the p- semiconductor layer 14A in which the APDs 14 are formed. Subsequently, quench resistors 32 connected in series with the APDs 14 are formed in regions (hereinafter referred to as inactive regions) between the APDs 14 in the insulating layer 30A.

The quench resistors 32 are on a path of charges amplified by p-n junctions of the APDs 14. Thus, the quench resistors 32 are required to drive the APDs 14 in the Geiger mode. For example, when one photon P is incident and causes Geiger discharge of an APD 14, a voltage drop caused by the quench resistor 32 terminates the amplification operation. As a result, a pulsed output signal is obtained by the APD 14. In the photodetection layer 12, the respective APDs 14 operate in this manner. As a result, when Geiger discharge is caused in multiple APDs 14, an output signal having a charge amount or a pulse peak value several times larger than that in an APD 14 where Geiger discharge is caused is obtained for the output signal from one APD 14. Since the number of APDs 14 in which Geiger discharge is caused, that is, the number of photons P incident on the photodetection layer 12 can be counted from the output signal, photons can therefore be measured one by one.

For the quench resistors 32, polysilicon may be used, for example.

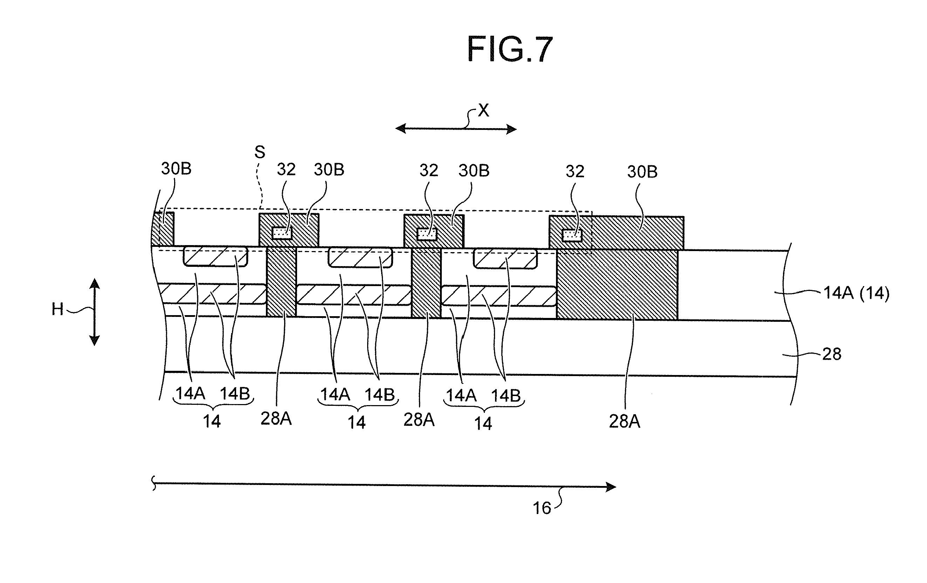

Subsequently, regions in the insulating layer 30A in which the antireflective member 20 and an antireflective member 21B (not illustrated in FIGS. 6 and 7) are to be formed are removed by etching. As a result, as illustrated in FIG. 7, the regions in the insulating layer 30A (see FIG. 6) in which the antireflective member 20 and the antireflective member 21B are to be formed are removed and regions (see the insulating layer 30B) other than the regions in which the antireflective members are to be formed remain. In FIG. 7, the regions surrounded by a dotted line S are actually positioned in the inactive regions between the APDs 14. Thus, the regions surrounded by the dotted line S are actually positioned in the inactive regions between the respective APDs 14 in FIG. 7 and APDs 14 adjacent to and behind the respective APDs 14 in FIG. 7. The same applies to FIGS. 8 to 12.

Subsequently, the insulating layer 30A is formed in the regions of the p- semiconductor layer 14A and the APDs 14 exposed by the etching (that is, the regions in which the antireflective member 20 and the antireflective member 21B are to be formed). Subsequently, an antireflective layer 21 is formed on the insulating layer 30A and the insulating layer 30B by using the material of the antireflective member 20 (see FIG. 8). For example, the antireflective layer 21 is formed by laminating a nitride film on an oxide film.

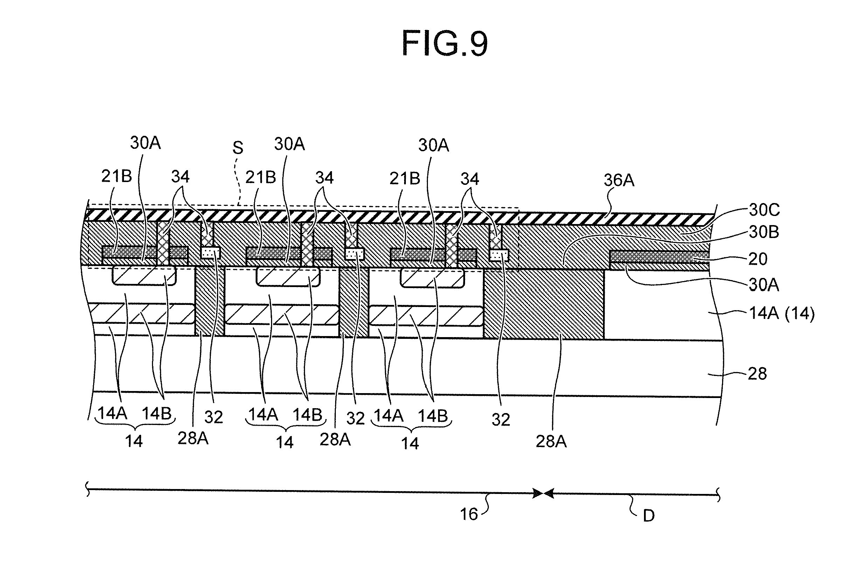

Subsequently, the antireflective member 20 and the antireflective member 21B are formed by removing regions in the antireflective layer 21 other than the regions in which the antireflective member 20 and the antireflective member 21B are to be formed (see FIG. 9). The antireflective member 20 is arranged between pixels (see a region D in FIG. 9). The length of the antireflective member 20 in the direction in which the APDs 14 are arranged (the direction of the arrow X or the direction of the arrow Y) is 200 µm, for example. The antireflective member 21B is arranged in the inactive regions between the APDs 14.

Subsequently, after forming an insulating layer 30C, a contact layer 34 for conduction between the APDs 14 and the quench resistors 32. A wiring layer 36A is then formed, and conduction between the wiring layer 36A and the quench resistors 32 via the contact layer 34 is formed.

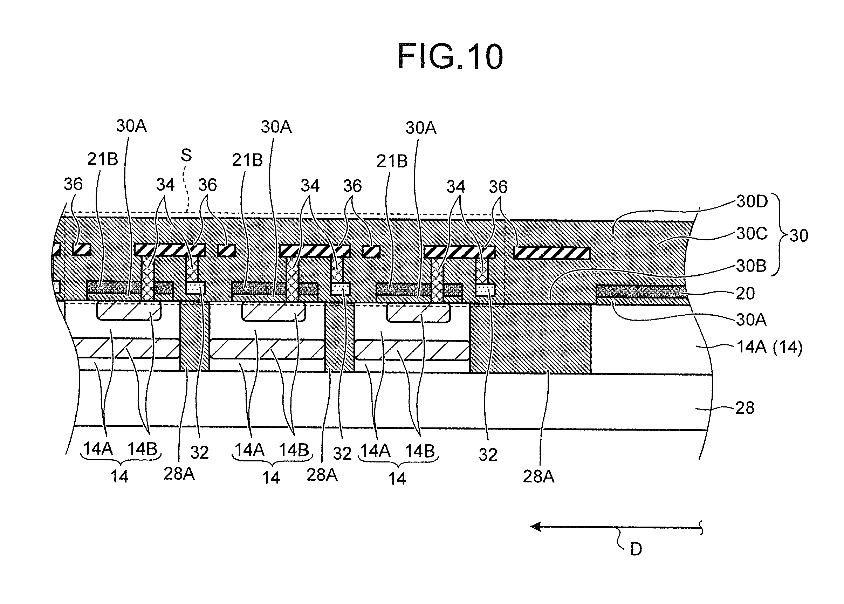

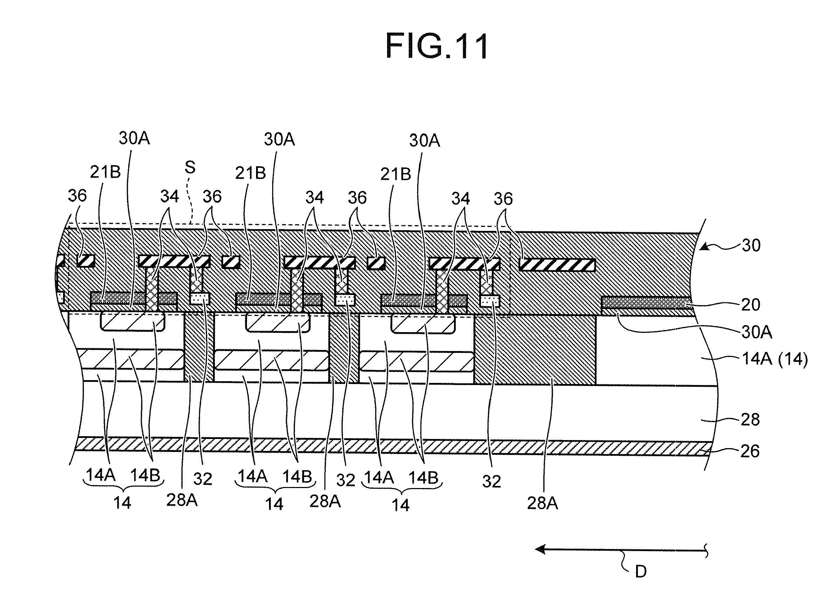

Subsequently, the wiring layer 36A illustrated in FIG. 9 is patterned. As a result, a wiring layer 36 illustrated in FIG. 10 is formed. Subsequently, an insulating layer 30D is formed on the wiring layer 36 and the insulating layer 30C. Subsequently, as illustrated in FIG. 11, an electrode layer 26 is formed on a back surface of the N-type semiconductor substrate 28. The electrode layer 26 functions as a cathode electrode.

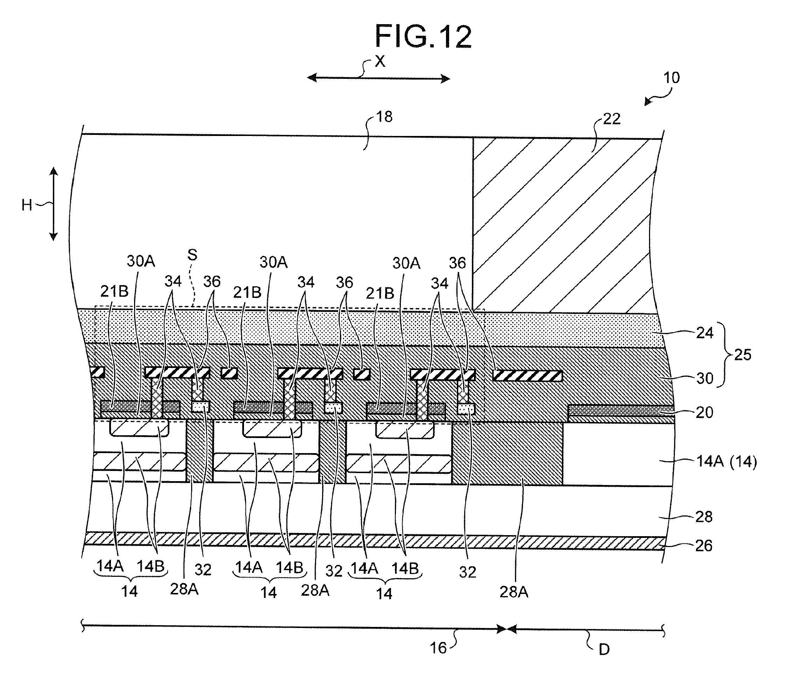

Subsequently, as illustrated in FIG. 12, a scintillator layer 18 is provided. The scintillator layer 18 is divided into regions associated with the pixel regions 16 by the reflective member 22. The length in the direction in which the pixel regions 16A are arranged (the direction of the arrow X or the direction of the arrow Y) of the regions of the scintillator layer 18 into which the scintillator layer 18 is divided by the reflective member 22 and which are associated with the respective pixel regions 16 is 900 µm, for example. In addition, the width of the surface of the reflective member 22 opposed to the antireflective member 20 is 100 µm, for example. Subsequently, the scintillator layer 18 divided into regions associated with the pixel regions 16 by the reflective member 22 is joined to the insulating layer 30 (the insulating layer 30D, the insulating layer 30B, and the insulating layer 30C) via the adhesive layer 24. The thickness of the adhesive layer 24 is 50 µm, for example. In this manner, the photodetector 10 is produced.

As described above, the photodetector 10 of the present embodiment includes the antireflective member 20 between pixels on the surface of the photodetection layer 12 facing the scintillator layer 18. As a result, even if photons P resulting from the conversion by the scintillator layer 18 propagate in the direction in which the pixel regions 16 are arranged owing to multiple reflection in the intermediate layer 25 between the photodetection layer 12 and the scintillator layer 18, reflection thereof is prevented when the photons reaches the antireflective member 20 arranged between pixels. Thus, photons P are not detected in the pixel regions 16 around the associated pixel region 16, and optical crosstalk is prevented.

With the photodetector 10 of the present embodiment, optical crosstalk between pixels caused by multiple reflection of photons P in the intermediate layer 25 can therefore be reduced.

Furthermore, with the photodetector 10 of the present embodiment, since optical crosstalk can be reduced, output signals output from the respective pixel regions 16 are signals according to the number of photons P incident on the regions of the scintillator layer 18 associated with the respective pixel regions 16. The accuracy of photon measurement with the photodetector 10 can therefore be significantly improved. Furthermore, decrease in spatial resolution and energy resolution can be overcome by applying the photodetector 10 of the present embodiment to acquisition of computed tomography (CT) images.

### Modified Example 1

In the embodiment described above, a case in which the antireflective member 20 is continuous and surrounds the pixel regions 16 on the surface of the photodetection layer 12 facing the scintillator layer 18 is described (see FIG. 1). The antireflective member 20 only needs to be provided between pixels on the surface of the photodetection layer 12 facing the scintillator layer 18, and is not limited to the embodiment illustrated in FIG. 1.

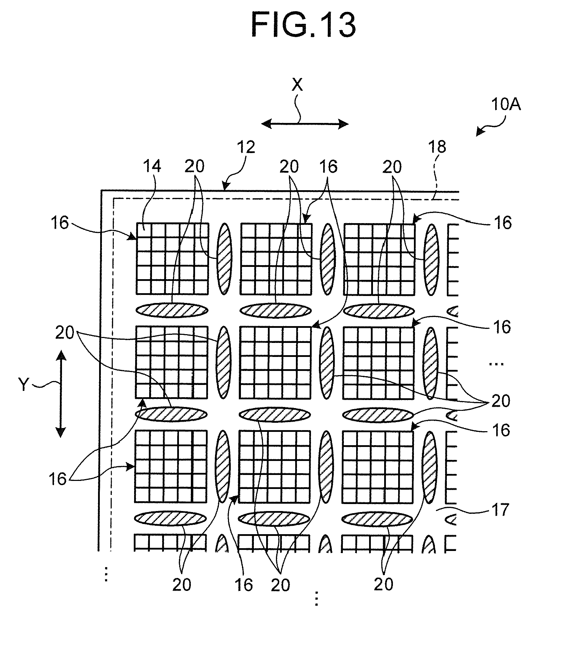

FIG. 13 is a diagram illustrating a photodetector 10A of the present modified example. As illustrated in FIG. 13, the antireflective member 20 may be provided in a discontinuous manner in the direction along the surface between pixels on the surface of the photodetection layer 12 facing the scintillator layer 18. The photodetector 10A is the same as the photodetector 10 illustrated in FIG. 1 except that the arrangement of the antireflective member 20 between pixels is different.

### Modified Example 2

In the example illustrated in FIG. 2, a case in which the antireflective member 20 has a width equal to the distance between pixels is described. The antireflective member 20, however, may have a width smaller than the distance between pixels.

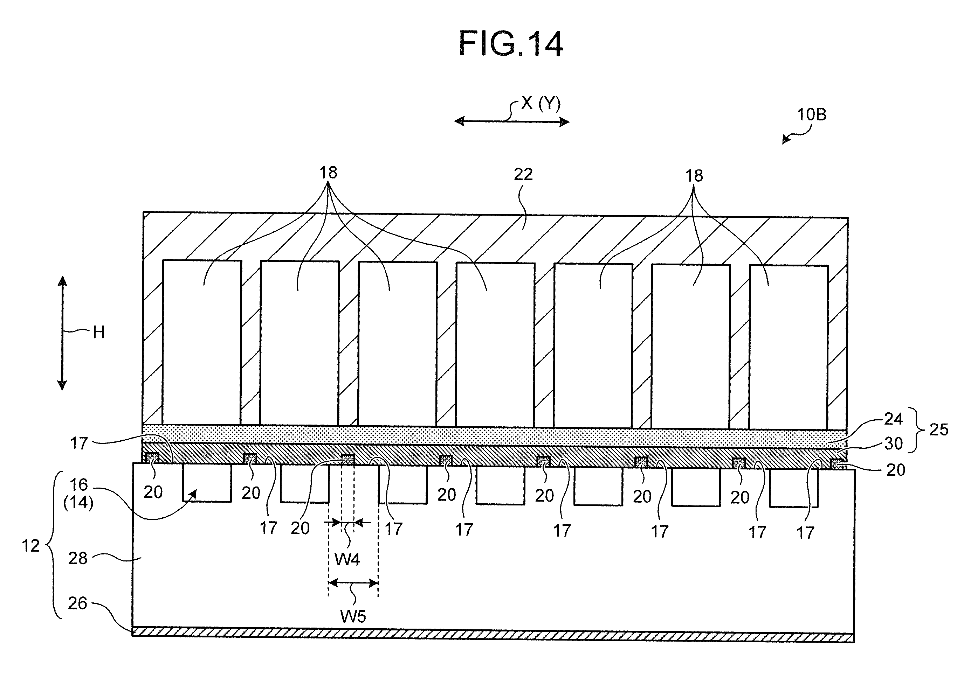

FIG. 14 is a diagram illustrating a photodetector 10B of the present modified example. As illustrated in FIG. 14, the antireflective member 20 may have a width (see a width W4 in FIG. 14) smaller than the distance (see a width W5 in FIG. 14) between pixels. The photodetector 10A is the same as the photodetector 10 illustrated in FIG. 2 except that the position of the antireflective member 20 between pixels is different.

### Modified Example 3

In the example illustrated in FIG. 2, a case in which the position and the cross-sectional shape of the antireflective member 20 in the thickness direction (the direction of an arrow H) of the photodetector 10 are such that the antireflective member 20 includes positions corresponding to the light receiving surfaces of the APDs 14 and that the cross-sectional shape is a rectangle protruding from the position toward the scintillator layer 18 is described. The position and the cross-sectional shape of the antireflective member 20 in the thickness direction (see the direction of the arrow H in FIG. 2) of the photodetector 10, however, may be any position and shape such that the antireflective member 20 includes regions corresponding to the light receiving surfaces of the APDs 14, and are not limited to the embodiment illustrated in FIG. 2.

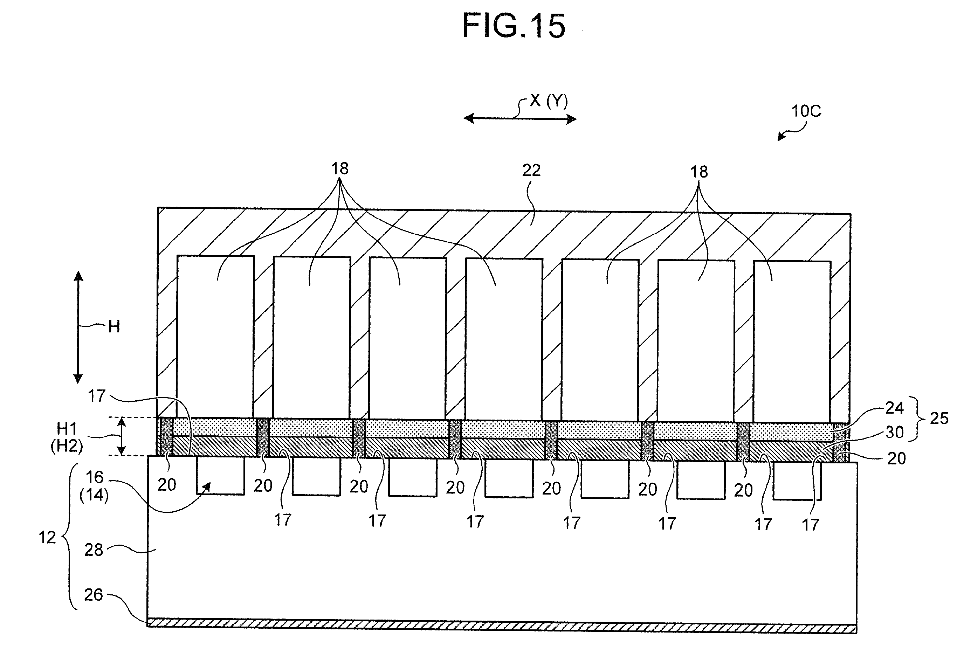

FIG. 15 is a diagram illustrating a photodetector 10C of the present modified example. As illustrated in FIG. 15, the antireflective member 20 may have a rectangular shape continuous from one end to another end of the intermediate layer 25 in the thickness direction (see the direction of the arrow H in FIG. 15). Specifically, the thickness (see the length in the direction of the arrow H and the thickness H2 in FIG. 15) of the antireflective member 20 and the thickness (see the thickness H1 in FIG. 14) of the intermediate layer 25 may be equal to each other. Thus, the first surface of the photodetection layer 12 is in contact with the antireflective member 20, and the antireflective member 20 passes through the intermediate layer 25. The photodetector 10C is the same as the photodetector 10 illustrated in FIG. 2 except that the position and the cross-sectional shape in the thickness direction of the antireflective member 20 are different.

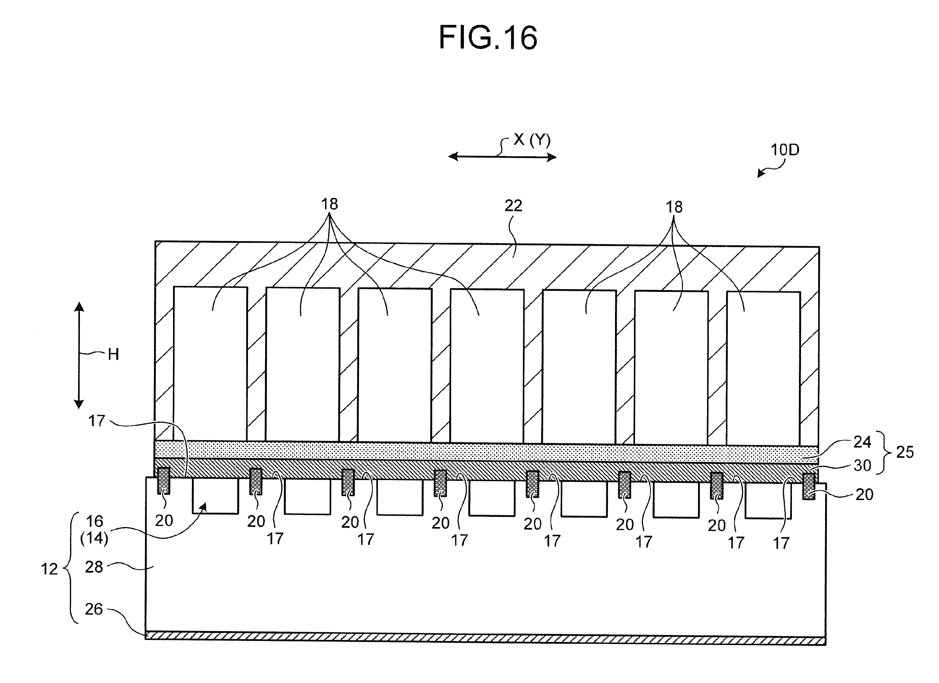

FIG. 16 is a diagram illustrating a photodetector 10D of the present modified example. As illustrated in FIG. 16, the position and the cross-sectional shape of the antireflective member 20 in the thickness direction (see the direction of the arrow H in FIG. 16) of the photodetector 10D are such that the antireflective member 20 includes positions corresponding to the light receiving surfaces of the APDs 14 and that the cross-sectional shape is a rectangle extending both toward the scintillator layer 18 and toward the direction opposite to the scintillator layer 18. Specifically, the first surface of the photodetection layer 12 is across the antireflective member 20 and covered by the intermediate layer 25. The photodetector 10D is the same as the photodetector 10 illustrated in FIG. 2 except that the position and the cross-sectional shape in the thickness direction of the antireflective member 20 are different.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A photodetector (10; 10A; 10B; 10C; 10D) comprising:
a scintillator layer (18) configured to convert radiation into light;
a photodetection layer (12) having a first surface facing the scintillator layer (18), the photodetection layer (12) including a pixel region (16) that includes multiple photodetection devices (14) configured to detect light, and a peripheral region (17) that surrounds the pixel region (16), the pixel region (16) and the peripheral region (17) being provided on the first surface;
an antireflective member (20) provided between the scintillator layer (18) and the photodetection layer (12) and opposed to at least part of the peripheral region (17), the antireflective member (20) being configured to prevent reflection of at least part of light in a sensitive wavelength range of the photodetection devices (14); and
an intermediate layer (25) provided in a region other than the antireflective member (20) between the scintillator layer (18) and the photodetection layer (12).

2. The photodetector (10; 10A; 10B; 10C; 10D) according to claim 1, wherein the first surface is in contact with the antireflective member (20) or across the antireflective member (20).

3. The photodetector (10; 10A; 10B) according to claim 1, wherein the first surface is in contact with the antireflective member (20) and covered with the intermediate layer (25).

4. The photodetector (10C) according to claim 1, wherein
the first surface is in contact with the antireflective member (20), and
the antireflective member (20) passes through the intermediate layer (25).

5. The photodetector (10D) according to claim 1, wherein the first surface is across the antireflective member (20), and
the antireflective member (20) is covered with the intermediate layer (25).

6. The photodetector (10; 10A; 10B; 10C; 10D) according to any one of claims 1 to 5, wherein
the intermediate layer (25) includes an insulating layer (30) provided in contact with the antireflective member (20) on a side of the scintillator layer (18), and
the antireflective member (20) has a refractive index different from that of the insulating layer (30).

7. The photodetector (10; 10A; 10B; 10C; 10D) according to claim 6, wherein the antireflective member (20) has a refractive index higher than that of the insulating layer (30).

8. The photodetector (10; 10A; 10B; 10C; 10D) according to any one of claims 1 to 5, wherein the antireflective member (20) cancels and interferes with light incident on the antireflective member (20).

9. The photodetector (10; 10A; 10B; 10C; 10D) according to claim 8, wherein the antireflective member (20) has an optical distance that is 1/4 of a wavelength of light incident on the antireflective member (20).

10. The photodetector (10; 10A; 10B; 10C; 10D) according to any one of claims 1 to 5, wherein the antireflective member (20) absorbs at least part of light in a sensitive wavelength region of the photodetection devices (14).

11. The photodetector (10; 10A; 10B; 10C; 10D) according to any one of claims 1 to 10, wherein
the scintillator layer (18) is divided into regions corresponding respectively to pixels by a reflective member, and
the antireflective member (20) is provided in a region opposed to the reflective member on a surface of the photodetection layer (12) facing the scintillator layer (18).
